# FASCICULE DE BREVET EUROPEEN

(11) **EP 2 342 732 B1**
(45) Date de publication et mention de la délivrance du brevet: **14.03.2018**
(21) Numéro de dépôt: 09749164.1
(22) Date de dépôt: 14.09.2009
(51) Int. Cl.: H01J 27/26, H01J 37/08

(54) **DISPOSITIF DE GÉNÉRATION D'UN FAISCEAU D'IONS AVEC FILTRE MAGNÉTIQUE**
EINRICHTUNG ZUM ERZEUGEN EINES IONENSTRAHLS MIT MAGNETFILTER
DEVICE FOR GENERATING AN ION BEAM WITH MAGNETIC FILTER

(30) Priorité: 15.09.2008 FR 0856189; 15.09.2008 FR 0856190
(43) Date de publication de la demande: 13.07.2011
(73) Titulaire: Centre National de la Recherche Scientifique (C.N.R.S.), 75016 Paris (FR)
(72) Inventeur: JEDE, Ralf, 58239 Schwerte (DE); GIERAK, Jacques, F-91220 Le Plessis Pate (FR)
(74) Mandataire: Lavoix
(86) Numéro de dépôt international: PCT/FR2009/051719
(87) Numéro de publication internationale: WO 2010/029269

(56) Documents cités:
- WO-A-02/078036
- JP-A- 60 133 635
- US-A- 4 272 699
- US-B1- 6 294 862
- LEUNG KA-NGO: "The application and status of the radio frequency driven multi-cusp ion source (invited)" REVIEW OF SCIENTIFIC INSTRUMENTS, AIP, MELVILLE, NY, US, vol. 71, no. 2, 1 février 2000 (2000-02-01), pages 1064-1068, XP012037925 ISSN: 0034-6748
- ORLOFF J: "FOCUSED ION BEAMS" SCIENTIFIC AMERICAN, SCIENTIFIC AMERICAN INC., NEW YORK, NY, US, vol. 265, no. 4, 1 octobre 1991 (1991-10-01), pages 74-79, XP000573576 ISSN: 0036-8733

## Description

La présente invention concerne un dispositif de génération d'un faisceau d'ions, comprenant : un support ; une source d'ions, cette source d'ions comportant une extrémité inférieure reliée au support et une extrémité supérieure, à l'opposé de l'extrémité inférieure ; et un moyen d'extraction des ions émis par la source, ce moyen d'extraction comprenant une paroi munie d'une ouverture, l'ouverture étant agencé à proximité de l'extrémité supérieure de la source d'ions, afin de permettre le passage des ions extraits à travers cette ouverture.

Un tel dispositif de génération d'un faisceau d'ions est connu du document WO 02/078036 A2.

On a constaté que la stabilité spatiale et temporelle du faisceau d'ions émis par un tel dispositif connu est limitée. Des effets de contamination, notamment dus à un bombardement par des électrons secondaires, tels que décrits dans l'article de P. Sudraud et al (1986), The effect of carbon bearing gases and secondary electron bombardment on a liquid metal ion source, Journal de Physique, C7, Tome 47, 381, nuisent à la stabilité de la source d'ions. Ces effets de contamination augmentent considérablement le bruit de la source d'ions et réduisent sa durée de vie.

Un but de l'invention est donc d'améliorer la stabilité spatiale et temporelle du faisceau d'ions émis par un dispositif tel qu'énoncé ci-dessus.

Ce but est atteint par un dispositif de génération d'un faisceau d'ions du type précité, où le dispositif comprend en outre un moyen de génération d'un champ magnétique apte à générer un champ magnétique au niveau de l'ouverture du moyen d'extraction, le champ magnétique généré étant apte à dévier des particules chargées attirées par la source d'ions de manière à ce que ces particules chargées n'atteignent pas la source d'ions, et où la source d'ions est une source d'ions à métal liquide.

En générant un champ magnétique au niveau de l'ouverture du moyen d'extraction, on arrive à dévier les électrons secondaires de leur trajectoire. Les électrons secondaires n'atteignent plus la source d'ions et ne peuvent donc plus perturber la zone d'émission des ions de cette source. Ainsi, la stabilité du dispositif de génération de faisceau d'ions est nettement améliorée, ce qui permet d'obtenir une linéarité de sa caractéristique I/V remarquable et sans comparaison avec un dispositif équivalent dont la source n'est pas protégée par un champ magnétique.

La protection de la source d'ions par un champ magnétique permet aussi d'augmenter sa durée de vie.

Le document US 6,294,862 décrit une source d'ions utilisant du gaz de phosphine comme « carburant », c'est-à-dire comme espèce d'apport à ioniser. Le gaz de phosphine est introduit dans une chambre de confinement et y est ionisé par bombardement aux électrons. Le plasma qui s'en suit est contenu dans la chambre à l'aide d'aimants répartis sur ses parois. Les cations de phosphore contenu dans le plasma quittent la chambre sous forme de faisceau à travers des ouvertures pratiquées dans une électrode de plasma agencée au niveau de l'une des parois de la chambre de confinement. Or, il s'avère que parmi les électrons présents dans le plasma et servant à ioniser le gaz de phosphine, ceux de haute énergie arrivent à quitter, ensemble avec les cations de phosphore, la chambre de confinement par lesdites ouvertures et « polluent » le faisceau d'ions. Afin de réduire la quantité d'électrons de haute énergie indésirables présents dans le faisceau d'ions, le document US 6,294,862, propose d'agencer des aimants autour des ouvertures de l'électrode de plasma. Le champ magnétique créé au niveau des ouvertures de l'électrode de plasma détourne les électrons de haute énergie desdites ouvertures. Ainsi, les électrons de haute énergie sont maintenus dans la chambre de confinement. En outre, l'électrode de plasma est maintenue à un potentiel légèrement négatif par rapport au reste de la chambre de confinement afin de repousser les anions du plasma dans l'espace de confinement. L'électrode de plasma, y compris ses aimants, sert donc exclusivement au confinement du plasma. L'extraction des cations de phosphore à travers les ouvertures de l'électrode de plasma est assurée par un composant distinct de l'électrode de plasma, à savoir une électrode d'extraction ordinaire située en aval de la source d'ions.

Suivant des modes particuliers de réalisation, le dispositif de génération d'un faisceau d'ions selon l'invention comprend une ou plusieurs des caractéristiques suivantes, prise(s) isolément ou suivant toutes les combinaisons techniquement possibles :
Le champ magnétique généré est apte à dévier les particules chargées de telle manière qu'elles rencontrent la paroi du moyen d'extraction au lieu d'atteindre, en traversant l'ouverture du moyen d'extraction, la source d'ions ;
Le moyen de génération d'un champ magnétique est agencé au niveau de l'ouverture du moyen d'extraction ;
L'ouverture du moyen d'extraction est réalisée dans un renfoncement du moyen d'extraction, le moyen de génération d'un champ magnétique étant placé à l'intérieur de ce renfoncement, en bordure de ladite ouverture ;
Le moyen de génération d'un champ magnétique comprend au moins un aimant permanent ;
Le moyen de génération d'un champ magnétique est composé de deux aimants permanents placés en vis-à-vis ;
Les deux aimants permanents définissent entre eux un entrefer de préférence ajustable d'environ 2 à environ 4 mm ;
Le champ magnétique induit par les deux aimants permanents dans l'entrefer est de l'ordre de 0,1 à 1 Tesla ;
Le moyen d'extraction des ions est une électrode d'extraction entourant la source d'ions ;
La source d'ions est entourée d'un piège cryogénique maintenu à basse température, ce piège cryogénique étant apte à piéger des espèces chimiques volatiles par condensation avant qu'elles ne puissent atteindre la source d'ions ;
Le piège cryogénique est maintenu à basse température par :
   - circulation ou accumulation d'un fluide cryogénique, le fluide cryogénique étant de préférence de l'azote liquide ; ou
   - un réfrigérateur mécanique générant une faible émission de vibrations ; ou
   - un réfrigérateur électrique ;
Le piège cryogénique est maintenu à une température inférieure à 100 K ;
Le piège cryogénique comprend une gaine à deux extrémités ouvertes entourant la source d'ions ;
Le piège cryogénique comprend un tube spiralé à fluide cryogénique enroulé autour de la gaine ;
L'une des extrémités ouvertes de la gaine sert au passage du faisceau d'ions produit par la source d'ions ;
La gaine est formée par une paroi de révolution, cette paroi comprenant une première section de forme cylindrique et une deuxième de forme tronconique ;
Le piège cryogénique entoure à la fois la source d'ions et le moyen d'extraction ;
La source d'ions à métal liquide comprend une tige conductrice terminée par une pointe, un réservoir fixé à la tige et servant à accueillir une charge de métal à liquéfier, ainsi qu'un filament conducteur comportant des enroulements traversés par la pointe de la tige.

En outre l'invention concerne une installation à faisceau d'ions focalisé comprenant :
- une chambre de travail contenant un support d'échantillon et une amenée de gaz réactifs à proximité du support d'échantillon ; et
- une colonne à plusieurs étages, dont un premier étage de génération du faisceau d'ions et un deuxième étage d'orientation et de focalisation du faisceau d'ions,
installation dans laquelle le premier étage comporte un dispositif de génération d'un faisceau d'ions tel qu'énoncé ci-dessus.

L'invention sera mieux comprise à la lecture de la description qui va suivre, donnée uniquement à titre d'exemple, et faite en se référant aux dessins annexés.
La figure 1 est une vue en perspective écorchée d'une installation à faisceau d'ions focalisé selon un mode de réalisation de l'invention ;
La figure 2 est une vue en coupe longitudinale de la colonne de l'installation de la figure 1, selon les flèches I-I ;
La figure 3 est une vue de côté, partiellement en coupe, du dispositif de génération d'un faisceau d'ions intégré dans l'installation selon la figure 1 ;
La figure 4 est une vue en coupe d'un détail de la figure 3, selon les flèches II-II ; et
La figure 5 est une vue frontale de l'ouverture d'émission du dispositif de la figure 3, selon la flèche III.

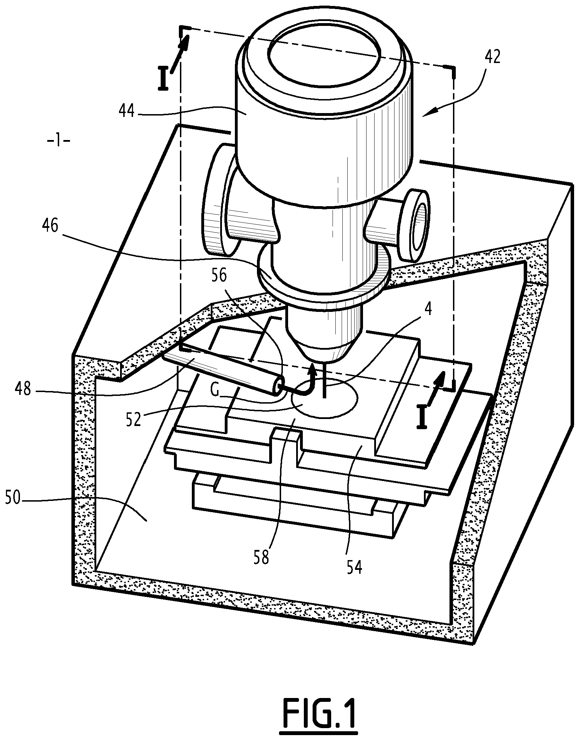

La figure 1 montre une installation 1 à faisceau d'ions focalisé selon l'invention. Cette installation 1 comporte une chambre de travail 50 de forme parallélépipède maintenue sous vide ainsi qu'une colonne 42 de forme généralement cylindrique. La colonne 42 traverse l'une des parois de la chambre de travail 50 et s'étend avec une de ses extrémités à l'intérieur de celle-ci.

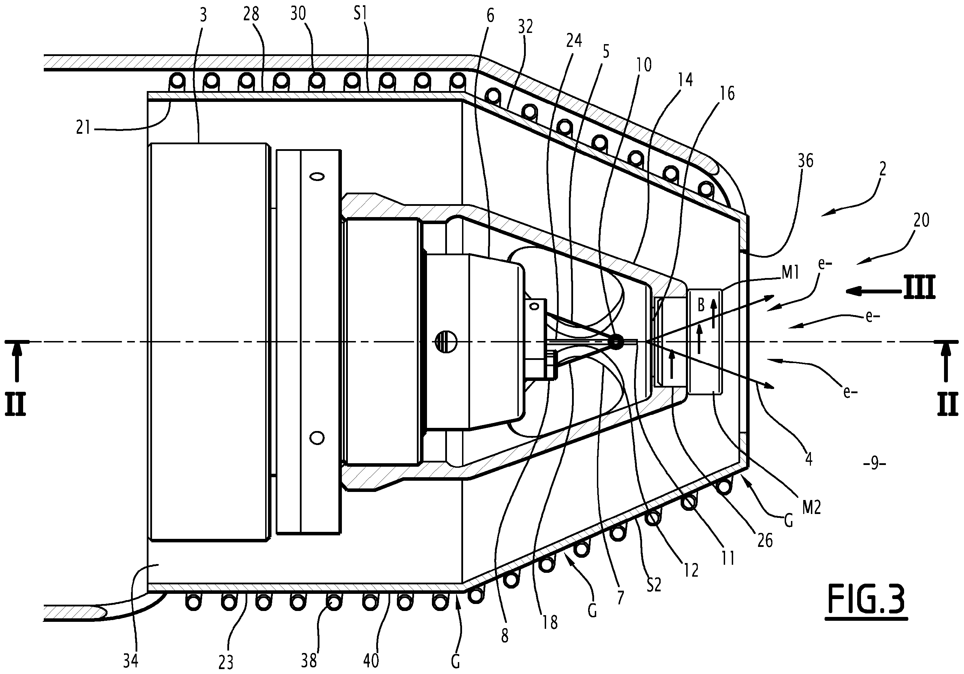

La colonne 42 dispose de plusieurs étages, et notamment d'un premier étage 44 contenant un dispositif 2 de génération d'un faisceau d'ions (cf. la figure 3), et d'un deuxième étage 46 contenant des moyens d'orientation et de focalisation du faisceau d'ions généré à l'intérieur du premier étage.

La chambre de travail 50 contient un support 54 qui sert à tenir et à positionner un échantillon 52 avec une précision nanométrique en trois dimensions. A cet effet, le support 54 comprend de préférence un interféromètre laser.

En outre, la chambre de travail 50 contient une amenée de gaz 48, dont l'ouverture 56 se situe à proximité de la zone de travail 58 du support 54 apte à accueillir un échantillon 52.

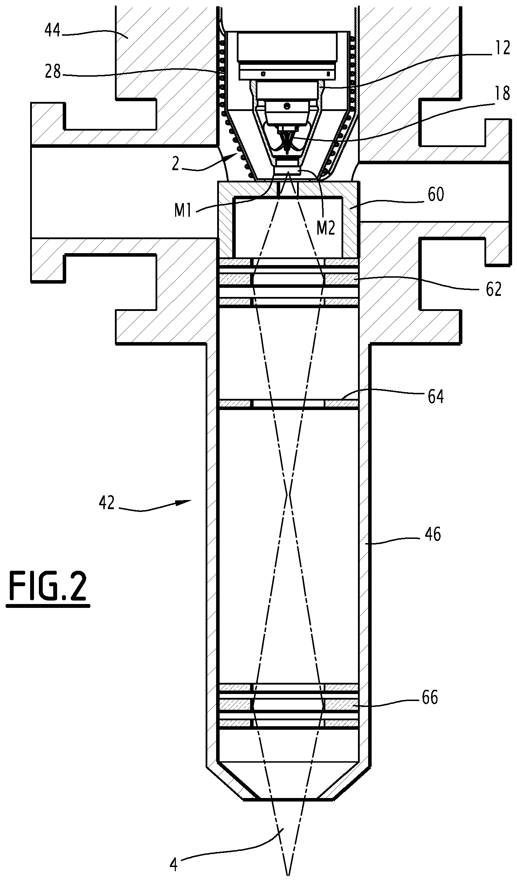

La figure 2 donne un aperçu schématique des éléments principaux présents à l'intérieur de la colonne 42. On distingue, du haut vers le bas, la source d'ions 18, l'électrode d'extraction 12, l'accélérateur 60, une première lentille 62, un diaphragme 64, et une deuxième lentille 66.

La figure 3 illustre un dispositif de génération d'un faisceau d'ions, ce dispositif étant désigné par la référence 2. Ce dispositif 2 se situe à l'intérieur d'un espace 9 du premier étage 44, l'espace étant maintenu sous vide. Le dispositif 2 comprend une source d'ions 18 qui est entourée d'une électrode d'extraction 12. La source d'ions 18 ainsi que l'électrode d'extraction 12 sont fixées sur un support 6. On voit également une embase 3 sur laquelle est montée le support 6.

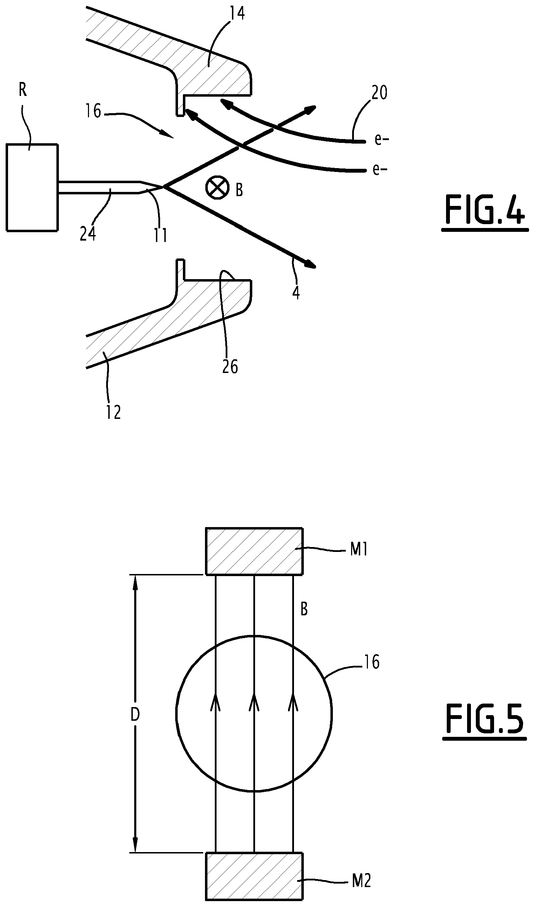

La source 18 comprend une tige conductrice 24 terminée par une pointe 11, un réservoir R (cf. la figure 4) fixé à la tige 24 et servant à accueillir une charge de métal d'apport à liquéfier, ainsi qu'un filament conducteur 5 comportant des enroulements. Ces enroulements sont traversés par la pointe 11 de la tige 24. La tige 24 et le réservoir R sont constitués d'un matériau conducteur et réfractaire, tel que le graphite ou le tungstène. Le métal d'apport est un matériau de haute pureté qui est incorporé à la source d'ions 18 avant son utilisation.

On dénommera « extrémité inférieure » l'extrémité 8 de la source d'ions 18 située à proximité du support 6. L'extrémité 10 de la source d'ions 18 à l'opposé de l'extrémité inférieure 8 sera dénommée « extrémité supérieure ». Cette extrémité supérieure 10 comprend la pointe 11 de la tige 24.

L'électrode d'extraction 12 est pourvue d'une ouverture 16, appelée « diaphragme d'extraction », et d'orifices tels que l'orifice 7, à travers lesquelles peuvent être pompés des gaz résiduels. L'ouverture 16 et lesdits orifices sont réalisés dans une paroi 14 de l'électrode d'extraction 12. L'ouverture 16 se situe au milieu d'un renfoncement cylindrique 26 de l'électrode d'extraction 12.

Les caractéristiques du dispositif 2 qui viennent d'être décrites sont connues, et, pour plus de détails, il est fait référence aux documents WO 02/078036 A2 et WO 96/02065. Par la suite, on s'intéressera aux nouveaux éléments objets de la présente invention.

Le dispositif 2 a la particularité de comprendre un piège cryogénique 28. Le piège 28 doit être suffisamment éloigné de la source d'ions 18 pour éviter un refroidissement du métal d'apport. Ce piège 28 comprend une gaine 32 entourant la source d'ions 18, ainsi que l'électrode d'extraction 12. La gaine 32 présente une section S1 de forme cylindrique et une section S2 de forme tronconique. La paroi de révolution 40 de la gaine 32 forme écran autour de la source d'ions 18. On distingue la surface interne 21 de la paroi 40 qui est tournée vers la source d'ions 18, et la surface externe 23 de la paroi 40 qui est tournée vers l'espace 9. En d'autres termes, la surface externe 23 est située d'un côté de la paroi 40, tandis que la source d'ions 18 est située de l'autre côté de la paroi 40.

La gaine 32 dispose de deux extrémités ouvertes 34 et 36. L'extrémité ouverte 34 permet l'insertion de la source d'ions 18 et de l'électrode d'extraction 12 à l'intérieur de la gaine 32. L'extrémité ouverte 36 permet le passage du faisceau d'ions 4 généré par la source d'ions 18.

Le piège cryogénique 28 comprend en outre un tube spiralé 38 enroulé autour de la gaine 32. Ce tube 38 permet la circulation ou l'accumulation d'un fluide cryogénique 30, de préférence de l'azote liquide.

Une deuxième nouveauté du dispositif 2 est l'ajout d'un filtre magnétique M1, M2. Ce filtre magnétique comprend deux aimants permanents M1 et M2 qui sont disposés en vis-à-vis à l'intérieur du renfoncement 26 de l'électrode d'extraction 12.

En référence à la figure 5, ces deux aimants M1 et M2 définissent entre eux un entrefer D. Cet entrefer D est de préférence ajustable entre environ 2 et 4 mm. Les deux aimants M1 et M2 induisent dans l'entrefer D un champ magnétique B, dont la valeur est de préférence de l'ordre de 0,1 à 1 Tesla. Le champ magnétique B est représenté aux figures 3 à 5 par des lignes de champ fléchées.

La figure 4 est une vue en coupe de la pointe de l'électrode d'extraction 12, selon la ligne II-II de la figure 3. La figure 4 représente donc une vue perpendiculaire à celle représentée par la figure 3. A la figure 4, on distingue le champ magnétique B dont les lignes de champ sont perpendiculaires au plan du dessin. On distingue aussi la pointe 11 de la tige conductrice 24 qui émet le faisceau d'ions 4. Les aimants M1 et M2 ne sont pas visibles à la figure 4 puisqu'ils se situent respectivement à l'arrière et à l'avant du plan du dessin.

La source d'ions 18 est une source d'ions à métal liquide, ou selon son appellation anglaise une « Liquid Metal Ion Source », communément abrégée « LMIS ». Une telle LMIS est apte à générer un faisceau d'ions métalliques, par exemple un faisceau d'ions de gallium ou d'aluminium. Plus précisément, un courant est passé à travers le filament conducteur 5 qui, par effet Joule, chauffe le réservoir R de métal ainsi que la tige 24. La charge de métal présente dans le réservoir R est ainsi liquéfiée et se répand sur la surface de la tige 24, et notamment sur la pointe 11. L'électrode d'extraction 12 arrache des ions métalliques de la couche de métal liquide recouvrant l'apex de la pointe 11.

Les ions métalliques arrachés sont attirés par l'électrode d'extraction 12 et traversent l'ouverture 16. Ils quittent le dispositif 2, puis le premier étage 44, sous forme de faisceau 4. Le faisceau d'ions 4 atteint le deuxième étage 46 pour y être orienté et focalisé sur un échantillon 52 situé à l'intérieur de la chambre de travail 50. Le traitement de la surface de l'échantillon 52 par le faisceau 4 s'effectue par déplacement du support 54. Le faisceau d'ions 4 peut être qualifié de faisceau primaire, et les produits induits par l'utilisation du faisceau 4 sur l'échantillon 52 de sous-produits secondaires.

Le piège cryogénique 28 a été ajouté au dispositif 2 afin de le rendre compatible avec les techniques d'injection de gaz fréquemment utilisées dans des applications industrielles de dispositifs de génération d'ions. Ces techniques d'injection consistent à introduire des gaz réactifs ou précurseurs dans la chambre de travail 50 à l'aide d'une ou plusieurs amenées de gaz, tel que l'amenée 48, afin de diversifier ou d'améliorer et d'accélérer le traitement des échantillons 52 par le faisceau d'ions 4.

Une première de ces techniques est déployée lorsque le faisceau d'ions 4 est utilisé pour graver un échantillon. Des gaz réactifs sont acheminés par l'amenée 48 et la quitte en direction de l'échantillon 52. Les gaz réagissent avec les atomes de l'échantillon 52 pulvérisés par le faisceau 4 en formant des composés volatils. Les composés volatils sont évacués par le système de pompage de la chambre de travail 50. Ce procédé améliore la vitesse de gravure car il neutralise et évacue les déblais issus de la gravure.

La technique d'injection s'utilise aussi pour déposer des substances sur un échantillon. A cet effet, on introduit par l'amenée 48 des gaz précurseurs dans la chambre de travail 50 dont les molécules sont dissociées par l'action du faisceau d'ions 4. Les composés non volatils de cette réaction forment alors un dépôt solide adhérant à la surface de l'échantillon 52.

Dans le contexte d'une source d'ions à métal liquide, ces techniques d'injection présentent un inconvénient majeur. En effet, les gaz injectés dans la chambre de travail 50 diffusent à l'intérieur de celle-ci et pénètrent dans la colonne 42. A cause d'un gradient de pression favorable (le vide à l'intérieur du premier étage 44 est plus poussé que le vide au sein de la chambre de travail 50), ces gaz s'acheminent jusqu'à la source 18 et interagissent avec le métal liquide. Ces interactions ont des effets extrêmement néfastes sur la source d'ions 18, et la déstabilisent. Ainsi, Il devient impossible de maintenir la stabilité de l'émission d'ions sur des périodes de plusieurs heures.

Le piège cryogénique 28 permet de résoudre ce problème en protégeant la source d'ions 18 des vapeurs de gaz injecté. Le métal d'apport liquide est ainsi préservé. Grâce à son piège cryogénique, le dispositif 2 de génération de faisceau d'ions est compatible avec les techniques d'injection de gaz.

Le piège cryogénique 28 fonctionne de la manière suivante. On fait circuler de l'azote liquide 30 à l'intérieur du tube 38 afin de refroidir la paroi 40 de la gaine 32 à une température en dessous de 100 K. La gaine 32 ainsi refroidie constitue un piège pour les vapeurs de gaz injecté G, qui sont représentées aux figures 1 et 3 par des flèches ondulées. Ces espèces volatiles G entrent dans la colonne 42, traversent le deuxième étage 46 et atteignent le premier étage 44 pour ensuite se répandre dans l'espace 9 autour du dispositif 2 de génération d'un faisceau d'ions. Les vapeurs G sont arrêtées sur leur trajet vers la source d'ions 18 par la surface externe 23 de la paroi 40 qui forme barrage. Une fois arrêtées par la surface externe 23, les espèces G se refroidissent rapidement et perdent donc une grande partie de leur énergie cinétique. Les espèces G se condensent sur la surface externe 23 et se trouvent réellement « piégées ». Par manque d'énergie, elles restent « collées » au piège cryogénique 28 et ne peuvent donc plus atteindre la source d'ions 18.

Selon une variante de l'invention, le piège cryogénique comprend comme moyen de refroidissement un cryogénérateur/réfrigérateur mécanique ou bien un réfrigérateur électrique, de préférence un dispositif à effet dit « Peltier », au lieu d'un fluide cryogénique.

Le filtre magnétique M1, M2 a été ajouté au dispositif 2 afin d'empêcher les électrons secondaires 20 (cf. les figures 3 et 4) d'atteindre la source d'ions 18. Ces électrons secondaires 20 sont crées par l'impact d'ions du faisceau d'ions 4 sur les parois de l'environnement du dispositif 2. Ils sont attirés par le champ électrique local de forte intensité existant autour de la pointe 11. En absence du champ magnétique B, les électrons secondaires 20 pénètrent à l'intérieur de l'électrode d'extraction 12 par l'ouverture 16 et contaminent la source d'ions 18.

Grâce au champ magnétique B au niveau de l'ouverture 16, les électrons secondaires 20 sont déviés de leur trajectoire, tel qu'on peut le voir à la figure 4, et sont interceptés par la paroi 14 de l'électrode d'extraction 12 elle-même générant un champ électrostatique attracteur. Les électrons secondaires 20 sont ainsi neutralisés. Le filtre magnétique M1, M2 protège donc le métal liquide de la source d'ions 18 des électrons secondaires.

En revanche, l'influence du champ magnétique B sur la trajectoire des ions métalliques en provenance de la pointe 11 de la tige 24 à travers l'ouverture 16 est négligeable En effet, les ions métalliques disposent d'une masse et d'une énergie cinétique beaucoup plus élevées que les électrons secondaires. Ainsi, même en présence du champ magnétique B, la trajectoire des ions métalliques reste essentiellement inchangée.

Il convient de noter que le filtre magnétique selon l'invention peut aussi prendre d'autres formes que celle qui vient d'être décrite. En effet, pour atteindre le but recherché, il suffit d'un moyen quelconque, du moment qu'il soit apte à générer un champ magnétique adapté pour empêcher les électrons secondaires d'atteindre la source d'ions 18.

Le dispositif de génération d'un faisceau d'ions selon l'invention présente en particulier les avantages suivants :
- un fonctionnement plus stable de la source d'ions à faible courant d'émission (< 3 µA) grâce à l'élimination du courant d'électrons secondaires venant frapper la pointe émettrice ;
- une augmentation de la durée de vie de la source ;
- une meilleure pureté du faisceau d'ions émis par une protection accrue de la source ; et
- l'obtention d'un effet de pompage plus efficace dans la région de la source d'ions permettant de maintenir la source en émission dans un vide poussé (10 - 8 mbar) et ainsi de « gommer » l'influence des fluctuations de vide liées aux chargements et déchargements des échantillons qui pourront ainsi être multipliés à volonté sans endommager la source d'ions pouvant être laissée en fonctionnement.

En résumé, ce dispositif permet de préserver l'intégrité de la source d'ions et par voie de conséquence d'espacer le nombre et la fréquence (i) des opérations de décontamination généralement effectuées par un chauffage de la source lesquelles nécessitent d'interrompre l'utilisation, impliquent un nouveau réglage de l'instrument et induisent une perte par évaporation du métal liquide et (ii) de remplacements des sources arrivées en fin de vie.

L'invention permet d'améliorer la productivité du dispositif, l'utilisateur pouvant conserver les réglages opératoires (centrage optique de la source d'ions par rapport au système d'optique électrostatique, focalisation et correction de l'astigmatisme résiduel du faisceau) pendant des durées considérablement augmentées.

## Revendications

1. Dispositif (2) de génération d'un faisceau d'ions (4), comprenant :
- un support (6) ;
- une source d'ions (18) à métal liquide, cette source d'ions comportant une extrémité inférieure (8) reliée au support (6) et une extrémité supérieure (10), à l'opposé de l'extrémité inférieure (8) ; et
- un moyen (12) d'extraction des ions émis par la source, ce moyen d'extraction (12) comprenant une paroi (14) munie d'une ouverture (16), l'ouverture (16) étant agencé à proximité de l'extrémité supérieure (10) de la source d'ions (18), afin de permettre le passage des ions extraits à travers cette ouverture, **caractérisé en ce que** le dispositif comprend en outre un moyen (M1, M2) de génération d'un champ magnétique (B) apte à générer un champ magnétique au niveau de l'ouverture du moyen d'extraction, le champ magnétique généré (B) étant apte à dévier des particules chargées (20) attirées par la source d'ions de manière à ce que ces particules chargées n'atteignent pas la source d'ions.

2. Dispositif selon la revendication 1, dans lequel le champ magnétique généré est apte à dévier les particules chargées de telle manière qu'elles rencontrent la paroi du moyen d'extraction au lieu d'atteindre, en traversant l'ouverture du moyen d'extraction, la source d'ions.

3. Dispositif selon la revendication 1 ou 2, dans lequel le moyen de génération d'un champ magnétique est agencé au niveau de l'ouverture du moyen d'extraction.

4. Dispositif selon la revendication 3, dans lequel l'ouverture (16) du moyen d'extraction (12) est réalisée dans un renfoncement (26) du moyen d'extraction, le moyen de génération d'un champ magnétique étant placé à l'intérieur de ce renfoncement, en bordure de ladite ouverture.

5. Dispositif selon l'une quelconque des revendications précédentes, dans lequel le moyen de génération d'un champ magnétique comprend au moins un aimant permanent (M1, M2).

6. Dispositif selon la revendication 5, dans lequel le moyen de génération d'un champ magnétique est composé de deux aimants permanents (M1, M2) placés en vis-à-vis.

7. Dispositif selon la revendication 6, dans lequel les deux aimants permanents définissent entre eux un entrefer (D) de préférence ajustable d'environ 2 à environ 4 mm.

8. Dispositif selon la revendication 7, dans lequel le champ magnétique induit par les deux aimants permanents dans l'entrefer est de l'ordre de 0,1 à 1 Tesla.

9. Dispositif selon l'une quelconque des revendications précédentes, dans lequel le moyen d'extraction des ions est une électrode d'extraction (12) entourant la source d'ions.

10. Dispositif selon l'une quelconque des revendications précédentes, dans lequel la source d'ions (18) est entourée d'un piège cryogénique (28) maintenu à basse température, ce piège cryogénique étant apte à piéger des espèces chimiques volatiles (G) par condensation avant qu'elles ne puissent atteindre la source d'ions (18).

11. Dispositif selon la revendication 10, dans lequel le piège cryogénique (28) est maintenu à basse température par :
- circulation ou accumulation d'un fluide cryogénique (30), le fluide cryogénique étant de préférence de l'azote liquide ; ou
- un réfrigérateur mécanique générant une faible émission de vibrations ; ou
- un réfrigérateur électrique.

12. Dispositif selon la revendication 10 ou 11, dans lequel le piège cryogénique est maintenu à une température inférieure à 100 K.

13. Dispositif selon l'une quelconque des revendications 10 à 12, dans lequel le piège cryogénique comprend une gaine (32) à deux extrémités ouvertes (34, 36) entourant la source d'ions (18).

14. Dispositif selon la revendication 13, dans lequel le piège cryogénique comprend un tube spiralé (38) à fluide cryogénique enroulé autour de la gaine (32).

15. Dispositif selon la revendication 13 ou 14, dans lequel l'une (36) des extrémités ouvertes de la gaine sert au passage du faisceau d'ions produit par la source d'ions.

16. Dispositif selon l'une quelconque des revendications 13 à 15, dans lequel la gaine (32) est formée par une paroi de révolution (40), cette paroi comprenant une première section (S1) de forme cylindrique et une deuxième section (S2) de forme tronconique.

17. Dispositif selon l'une quelconque des revendications 10 à 16, dans lequel le piège cryogénique (28) entoure à la fois la source d'ions (18) et le moyen d'extraction (12).

18. Dispositif selon la revendication 1, dans lequel la source d'ions (18) à métal liquide comprend une tige conductrice (24) terminée par une pointe (11), un réservoir (R) fixé à la tige (24) et servant à accueillir une charge de métal à liquéfier, ainsi qu'un filament conducteur (5) comportant des enroulements traversés par la pointe (11) de la tige (24).

19. Installation (1) à faisceau d'ions focalisé comprenant :
- une chambre de travail (50) contenant un support (54) d'échantillon et une amenée (48) de gaz réactifs à proximité du support (54) d'échantillon ; et
- une colonne (42) à plusieurs étages, dont un premier étage (44) de génération du faisceau d'ions et un deuxième étage (46) d'orientation et de focalisation du faisceau d'ions,
installation dans laquelle le premier étage (44) comporte un dispositif selon l'une quelconque des revendications précédentes.

## Patentansprüche

1. Vorrichtung (2) zum Erzeugen eines lonenstrahls (4), umfassend:
- einen Halter (6);
- eine Flüssigmetall-Ionenquelle (18),
wobei diese lonenquelle ein unteres Ende (8), das mit dem Halter (6) verbunden ist, und ein oberes Ende (10) entgegengesetzt zum unteren Ende (8) aufweist; und
- ein Mittel (12) zum Extrahieren von von der Quelle emittierten Ionen, wobei dieses Extrahiermittel (12) eine mit einer Öffnung (16) versehene Wand (14) umfasst, wobei die Öffnung (16) in der Nähe des oberen Endes (10) der lonenquelle (18) angeordnet ist, um den Durchgang der extrahierten Ionen durch diese Öffnung zu ermöglichen,
**dadurch gekennzeichnet, dass**
die Vorrichtung außerdem ein Mittel (M1, M2) zum Erzeugen eines Magnetfeldes (B) umfasst, das ausgebildet ist, ein Magnetfeld an der Öffnung des Extrahiermittels zu erzeugen, wobei das erzeugte Magnetfeld (B) geeignet ist, geladene, von der lonenquelle angezogene Partikel (20) derart abzulenken, dass diese geladenen Partikel nicht die lonenquelle erreichen.

2. Vorrichtung nach Anspruch 1, bei der das erzeugte Magnetfeld ausgebildet ist, die geladenen Partikel derart umzulenken, dass sie auf die Wand des Extrahiermittels treffen anstatt beim Durchqueren der Öffnung der Extrahiermittel die lonenquelle zu erreichen.

3. Vorrichtung nach Anspruch 1 oder 2, bei der das Mittel zum Erzeugen eines Magnetfeldes an der Öffnung des Extrahiermittels angeordnet ist.

4. Vorrichtung nach Anspruch 3, bei der die Öffnung (16) des Extrahiermittels (12) in einer Vertiefung (26) des Extrahiermittels realisiert ist, wobei das Mittel zum Erzeugen eines Magnetfeldes im Inneren dieser Vertiefung am Rand der Öffnung liegt.

5. Vorrichtung nach einem beliebigen der vorhergehenden Ansprüche, bei der das Mittel zur Erzeugung eines Magnetfeldes mindestens einen Permanentmagneten (M1, M2) umfasst.

6. Vorrichtung nach Anspruch 5, bei der das Mittel zur Erzeugung eines Magnetfeldes aus zwei Permanentmagneten (M1, M2) zusammengesetzt ist, die einander zugewandt sind.

7. Vorrichtung nach Anspruch 6, bei der die zwei Permanentmagnete zwischen sich einen Luftspalt (D) begrenzen, der vorzugsweise um 2 bis ungefähr 4 mm einstellbar ist.

8. Vorrichtung nach Anspruch 7, bei der das Magnetfeld, das von den zwei Permanentmagneten in den Luftspalt induziert wird, in der Größenordnung von 0,1 bis 1 Tesla beträgt.

9. Vorrichtung nach einem beliebigen der vorhergehenden Ansprüche, bei der das Extrahiermittel der Ionen eine Extrahierelektrode (12) ist, die die lonenquelle umgibt.

10. Vorrichtung nach einem beliebigen der vorhergehenden Ansprüche, bei der die lonenquelle (18) von einer Kühlfalle (28) umgeben ist, die bei tiefer Temperatur gehalten wird, wobei diese Kühlfalle geeignet ist, volatile chemische Stoffe (G) durch Kondensation einzufangen bevor diese die lonenquelle (18) erreichen.

11. Vorrichtung nach Anspruch 10, bei der die Kühlfalle (28) bei tiefer Temperatur gehalten wird durch:
- Zirkulation oder Akkumulation eines Kühlfluids (30), wobei das Kühlfluid vorzugsweise flüssiger Stickstoff ist; oder
- eine mechanische Kühlanlage, die eine schwache Schwingungsemission erzeugt; oder
- eine elektrische Kühlanlage.

12. Vorrichtung nach Anspruch 10 oder 11, bei der die Kühlfalle bei einer Temperatur kleiner als 100 K gehalten wird.

13. Vorrichtung nach einem beliebigen der Ansprüche 10 bis 12, bei der die Kühlfalle einen die lonenquelle (18) umgebenden Mantel (32) mit zwei offenen Enden (34, 36) umfasst.

14. Vorrichtung nach Anspruch 13, bei der die Kühlfalle ein Spiralrohr (38) mit Kühlfluid umfasst, das um den Mantel (32) gewickelt ist.

15. Vorrichtung nach Anspruch 13 oder 14, bei der eines (36) der offenen Enden des Mantels dazu dient, den von der lonenquelle erzeugten lonenstrahl hindurchzulassen.

16. Vorrichtung nach einem beliebigen der Ansprüche 13 bis 15, bei der der Mantel (32) aus einer rotationssymmetrischen Wand (40) gebildet wird, wobei diese Wand einen ersten zylinderförmigen Abschnitt (S1) und einen zweiten kegelstumpfförmigen Abschnitt (S2) aufweist.

17. Vorrichtung nach einem beliebigen der Ansprüche 10 bis 16, bei der die Kühlfalle (28) sowohl die lonenquelle (18) als auch das Extrahiermittel (12) umgibt.

18. Vorrichtung nach Anspruch 1, bei der die Flüssigmetall-Ionenquelle (18) einen leitenden Stab (24), der in einer Spitze (11) endet, einen an dem Stab (24) befestigten Behälter (R), der dazu dient, eine zu schmelzende Metallladung aufzunehmen, sowie einen leitenden Draht (5), der Windungen aufweist, die von der Spitze (11) des Stabs (24) durchquert werden, umfasst.

19. Anlage (1) mit fokussiertem lonenstrahl, umfassend:
- eine Arbeitskammer (50), die einen Probehalter (54) und eine Zuführung (48) von reaktivem Gas in der Nähe des Probenhalters (54) enthält; und
- eine Kolonne (42) mit mehreren Stufen, die eine erste Stufe (44) zum Erzeugen des lonenstrahls und eine zweite Stufe (46) zum Orientieren und Fokussieren des lonenstrahls aufweist,
wobei in der ersten Stufe (44) der Anlage eine Vorrichtung nach einem der vorhergehenden Ansprüche vorgesehen ist.

## Claims

1. Device (2) for generating an ion beam (4), comprising:
- a support (6) ;
- a liquid metal ion source (18),
this ion source comprising one lower end (8) connected to the support (6) and an upper end (10) opposite the lower end (8); and
- means (12) for extracting the ions emitted by the source, this extraction means (12) comprising a wall (14) provided with an opening (16), the opening (16) being arranged in the vicinity of the upper end (10) of the ion source (18), to allow the extracted ions to pass through this opening,
**characterized in that** the device further comprises means (M1, M2) for the generation of a magnetic field (B) capable of generating a magnetic field at the opening of the extraction means, the generated magnetic field (B) being capable of deflecting the charged particles (20) attracted by the ion source so that the charged particles do not reach the ion source.

2. The device according to claim 1, wherein the generated magnetic field is capable of deflecting the charged particles so that they meet the wall of the extraction means instead of reaching the ion source by passing through the opening of the extraction means.

3. The device according to claim 1 or 2, wherein the means for generating a magnetic field is arranged at the opening of the extraction means.

4. The device according to claim 3, wherein the opening (16) of the extraction means (12) is formed in a recess (26) of the extraction means, the means for generating a magnetic field being placed inside this recess, on the edge of said opening.

5. The device according to any of the preceding claims, wherein the means for generating a magnetic field comprises at least one permanent magnet (M1, M2).

6. The device according to claim 5, wherein the means for generating a magnetic field is composed of two permanent magnets (M1, M2) facing one another.

7. The device according to claim 6, wherein the two permanent magnets together define an air gap (D) that is preferably adjustable between about 2 to about 4 mm.

8. The device according to claim 7, wherein the magnetic field induced by the two permanent magnets in the air gap is of the order of 0.1 to 1 Tesla.

9. The device according to any of the preceding claims, wherein the ion extraction means is an extraction electrode (12) surrounding the ion source.

10. The device according to any of the preceding claims, wherein the ion source (18) is surrounded by a cryogenic trap (28) held at low temperature, this cryogenic trap being capable of trapping volatile chemical species (G) by condensation before they are able to reach the ion source (18).

11. The device according to claim 10, wherein the cryogenic trap (28) is held at a low temperature by:
- circulation or accumulation of a cryogenic fluid (30), the cryogenic fluid preferably being liquid nitrogen; or
- a mechanical refrigerator generating a low emission of vibrations; or
- an electric refrigerator.

12. The device according to claim 10 or 11, wherein the cryogenic trap is held at a temperature below 100 K.

13. The device according to any of claims 10 to 12, wherein the cryogenic trap comprises a sheath (32) with two open ends (34, 36) surrounding the ion source (18).

14. The device according to claim 13, wherein the cryogenic trap comprises a coiled tube (38) with cryogenic fluid, wound around the sheath (32).

15. The device according to claim 13 or 14, wherein one (36) of the open ends of the sheath is used for passing of the ion beam produced by the ion source.

16. The device according to any of claims 13 to 15, wherein the sheath (32) is formed by a wall of revolution (40), this wall comprising a first section (S1) of cylindrical shape and a second section (S2) of frusto-conical shape.

17. The device according to any of claims 10 to 16, wherein the cryogenic trap (28) surrounds both the ion source (18) and the extraction means (12).

18. The device according to claim 1, wherein the liquid metal ion source (18) comprises a conductive rod (24) ending in a tip (11), a reservoir (R) attached to the rod (24) and used to collect a source metal to be liquefied, and a conductive filament (5) comprising windings through which the tip (11) of the rod (24) passes.

19. Focused ion beam installation (1) comprising:
- a work chamber (50) containing a sample holder (54) and an inlet (48) for reagent gases in the vicinity of the sample holder (54); and
- a column (42) with several levels, including a first level (44) for generating an ion beam and a second level (46) for guiding and focusing the ion beam,
an installation in which the first level (44) comprises a device according to any of the preceding claims.
